# EUROPEAN PATENT APPLICATION

(11) **EP 2 654 091 A2**
(43) Date of publication of application: **23.10.2013**
(21) Application number: 13162707.7
(22) Date of filing: 08.04.2013
(51) Int. Cl.: H01L 31/18, B65G 49/06, H01L 21/67

(54) **Solar cell string layup system and method**

(30) Priority: 16.04.2012 US 201261624574 P
(71) Applicant: Komax Holding AG, 6036 Dierikon (CH)
(72) Inventor: Duncan, Bill, Elizabethtown, PA 17022 (US); Daniel, David, Manheim, PA 17545 (US); Dingle, Brad, Red Lion, PA 17356 (US); Ruan, Shuang, Seven Valleys, PA 17360 (US); Hendrix, Wayne, New Freedom, PA 17349 (US)
(74) Representative: Hirschberger, Petra

(57) **Abstract**

A system for layup of a solar cell string on a substrate includes a robotic arm having a pickbar attached to a free end thereof. The pickbar has an elongated body with a plurality of vacuum grippers spaced along the body each for gripping an individual solar cell of the solar cell string. A vacuum source applies a vacuum through the vacuum grippers to grip the solar cells and a controller connected to the robotic arm positioned the solar cell string gripped by the pickbar on a substrate. A pair of sensor assemblies mounted on the pickbar generates signals representing positions of portions of the solar cell string and features of the substrate. The controller responds to the signals for positioning the gripped solar cell string relative to the substrate.

## Description

### CROSS-REFERENCE TO RELATED APPLICATION

This application claims the benefit of U.S. provisional patent application serial no. 61/624,574 filed April 16, 2012.

### FIELD

This invention relates to the manufacture of solar cell panels or modules. More particularly, the invention is directed to a method and apparatus for the layup of solar cell strings onto substrates.

### BACKGROUND

Production of crystalline photovoltaic modules is done by electrically connecting groups of silicon solar cells. Typically, individual cells are connected by flat copper wires (ribbons) into electrical series arrangements known as strings. The cell to cell stringing connections are ordinarily done using a soldering process to attach the flat copper wires to the front and back surfaces of the cells.

Strings (typically comprised of ten or twelve cells each) are arranged next to each other in parallel rows to complete a rectangular matrix of cells. While matrix configurations can vary depending on the application, a typical matrix is comprised of six twelve-cell strings for a total of seventy-two cells.

Modules are usually made up of a sun-facing sheet (substrate) of tempered glass, encapsulant materials, a matrix of interconnected solar cells, a rear environmental sealing material, a framework for rigidity and mounting, and an electrical junction box.

Module assembly is commonly done in multiple steps, the first of which is known in the industry as "layup". Layup is accomplished by placing the tempered glass substrate face down on a work support, usually a conveyor, and placing materials onto it. One layer of encapsulant foil, often made from ethylene-vinyl acetate (EVA), is placed on the glass. Strings of cells are accurately placed onto the EVA foil, active (sunny) side down, in a matrix arrangement.

Following layup, the strings are then electrically connected to each other in an operation known to the industry as "bussing", which can be manually done, or in some cases, automatically done. Bussing is usually done by soldering tinned, flat copper conductors to the ends of the strings, electrically connecting them and fixing their locational relationship to each other.

After bussing, another layer of EVA encapsulant foil is placed on top of the matrix, followed by a final back-sheet layer, often made of polyvinyl fluoride (PVF), for environmental protection of the finished product.

Further process steps are done to pre-test, complete (laminate), and final test the assembly. The final product after all of these steps is known as a module.

After the layup step in the module assembly process, the pre-laminate passes through an inspection and bussing process which is typically performed by operators located on either side of the module. The first task of these operators is to verify the alignment of the solar cell strings relative to the glass and to each other. The operators perform this task by adjusting the strings if necessary, by hand, into position based on a template printed on an insulator plate which is aligned to the glass. Once the strings are positioned, the operators often apply adhesive tape to maintain the strings' position and solder the bussing material to the ends of the strings.

To make automatic placement of solar cell strings onto a glass substrate in a glass layup system, a robot placing the strings must be accurate and be properly guided to pick and place each string. Programmable machine vision systems have been used to inspect the cells and locate the strings, passing positional data to the robot system. Recent layup systems available from Komax Solar of York, PA have all utilized vision systems to determine the string position for robot pick and then place at a calculated position on the glass. The layup systems and their associated vision systems include:
- Generation 1 - utilizes a vision table;
- Generation 2 (aka GL20) - utilizes pickbar vision cameras; and
- Generation 3 (aka GL30) - utilizes a vision tower.

In Komax Solar's Generation 1 glass layup system, there is a backlit inspection table onto which the robot (a gantry system) places a string produced by the XCELL stringer(s). A machine vision system, programmed to inspect for quality and calculate position, scans the string while it is on the inspection table. The camera is mounted on a servo motor controlled axis, and moves independently of the gantry robot system. The inspection is done by comparing measured data to thresholds stored in controller memory, and positional data collected is used to guide the robotic motions to pick and place the string onto the glass within a certain degree of accuracy.

The Generation 2 glass layup system uses a light table that is similar to the one used on Generation 1 system. The camera, however, is mounted on the six-axis robot that picks and places the strings, so that the robot replaces the servo axis in the Generation 1 system.

The Generation 3 glass layup system uses a "vision tunnel" approach. The design includes a vertical tower located within reach of the robot arm. A camera is mounted at the bottom of the tower pointed upward toward an area of controlled illumination designed for optimal machine vision lighting conditions. A string of cells held by the robot is moved through the controlled lighting at the top of the tunnel as images are collected by the machine vision camera. From the images obtained by the camera the software is able to capture defects and the positional information required for string placement on the panel.

The performance of current vision guided placement techniques has limitations which result in inaccuracies during placement of the strings, resulting in the need to manually reposition strings at the bussing step.

Module manufacturers looking to gain advantages in quality or labor cost savings may desire to eliminate the need for manual string position adjustment. Having well aligned strings directly from the automatic layup allows automated bussing, which also represents an opportunity for improved quality and labor cost savings.

The invention involves an innovative solution for string placement with a greatly improved accuracy.

### SUMMARY

With all of the methods described above, the performance is evaluated using test strings. These strings are flat sheets of metal material used for calibration, setup, and performance qualification. The purpose of the test strings is to remove all the variability of the string geometries; cell variation, string bow, cell positioning, which occur when standard material is used. In addition they provide a very rigid test material to measure performance, such as string to string gap and string to glass distance, using calipers. Typical performance with test strings is within acceptable tolerances for today's manufacturing lines utilizing manual bussing of +/- 0.3mm to +/- 0.5mm depending on the product generation.

Evaluating performance on real strings presents unique challenges which are typically not seen when using test strings and typically results in worse performance. Adding to the performance degradation are the inaccuracies in measuring the dimensional information on real product to quantify the performance. The material is very thin, fragile, and lightweight, making it a challenge to locate the edge and measure without moving the material using calipers. Performance on real material can degrade as much as two times the level achieved on test strings. This level of performance is not acceptable for today's manufacturing lines.

In addition to marginal performance, the solar industry is becoming more and more competitive and manufacturers are being held to higher standards of quality for the panels. Key quality standards are based on, not only panel performance, but their appearance. The dimensional consistency of the panels determines the appearance quality. The strings must be evenly spaced and the matrix must be centered on the glass. These aspects are the driving factors to improve layup performance requiring innovative technological developments.

The invention relates to a pickbar for layup of a solar cell strings on a substrate comprising: an elongated body having a plurality of vacuum grippers mounted thereon each spaced along the body for gripping an individual solar cell of a solar cell string when the vacuum grippers are connected to a vacuum source; and at least one sensor mounted on the pickbar for generating a signal representing a position of the solar cell string when gripped by the vacuum grippers, the position signal including a feature of a solar cell substrate when the pickbar is adjacent the substrate.

The invention relates to a system for layup of a solar cell string on a substrate comprising: a robotic arm; a pickbar attached to a free end of the robotic arm for gripping a solar cell string, the pickbar having an elongated body with a plurality of vacuum grippers spaced along the body each for gripping an individual solar cell of the solar cell string; a vacuum source in fluid communication with the vacuum grippers and applying a vacuum through the vacuum grippers to grip the solar cells; and a controller connected to the robotic arm for positioning the solar cell string gripped by the pickbar on a substrate. The system includes a pair of sensors mounted on the pickbar for generating signals representing positions of portions of the solar cell string and features of the substrate, the controller being connected to the sensors and being responsive to the signals for positioning the gripped solar cell string relative to the substrate.

The invention also relates to a method for layup of a solar cell string on a substrate comprising the steps of: providing a pickbar having an elongated body with a plurality of vacuum grippers and a sensor mounted thereon; positioning the pickbar adjacent a solar cell string and applying vacuum to the vacuum grippers to grip the solar cell string; moving the pickbar to position the solar cell string adjacent a surface of a substrate; operating the sensor to generate a signal representing a position of a portion of the solar cell string and features of the substrate; and moving the pickbar in response to the signal to place the solar cell string at a desired position on the substrate and release the solar cell string from the pickbar.

The advantages of this invention can be summarized as follows:
- Improved String Alignment - this refers to string alignment to other strings as well as the glass edge. Target performance goals are +/- 0.5mm for alignment to glass and +/- 0.2mm for alignment string to string. This is driven by higher quality standards and the additional industry trend towards higher degrees of automation (automated bussing).
- Automated Measurement - in addition to using sensors for positional feedback to the robot they can also be used to validate the position once the string has been placed. This information can not only be used to validate performance for setup, but also used as a control parameter during manufacturing.

### DESCRIPTION OF THE DRAWINGS

The above, as well as other advantages of the present invention, will become readily apparent to those skilled in the art from the following detailed description of a preferred embodiment when considered in the light of the accompanying drawings in which:

Fig. 1 is a perspective view of a pickbar used in the method and system of the invention;

Fig. 2 is a plan view of a typical solar cell string matrix placed on a glass substrate;

Fig. 3 is perspective view of the pickbar of Fig. 1 showing two sensors;

Fig. 4 is a plan view of an image of four solar cells for positioning a string adjacent another string according to the invention;

Fig. 5 is an elevation view of one of the sensors shown in Fig. 3;

Fig. 6 is a perspective view of the solar cell string layup system according to the invention; and

Fig. 7 is a block diagram of the control system for performing the method according to the invention.

### DETAILED DESCRIPTION

The U.S. provisional patent application Serial No. 61/624,574 filed April 16, 2012 is incorporated herein by reference.

The following detailed description and appended drawings describe and illustrate various exemplary embodiments of the invention. The description and drawings serve to enable one skilled in the art to make and use the invention, and are not intended to limit the scope of the invention in any manner. In respect of the methods disclosed, the steps presented are exemplary in nature, and thus, the order of the steps is not necessary or critical.

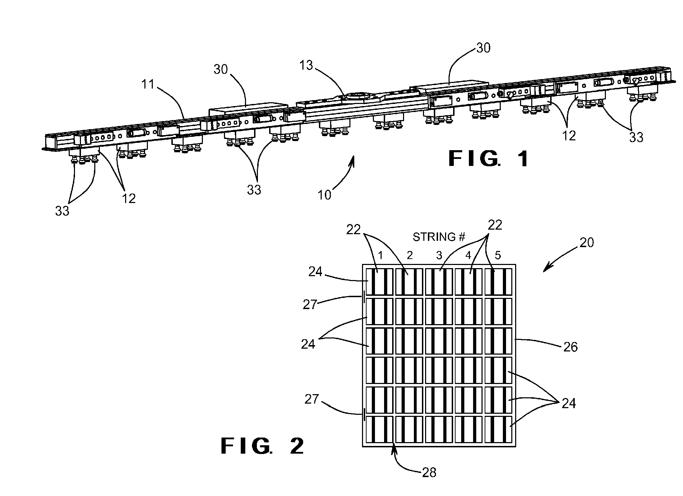

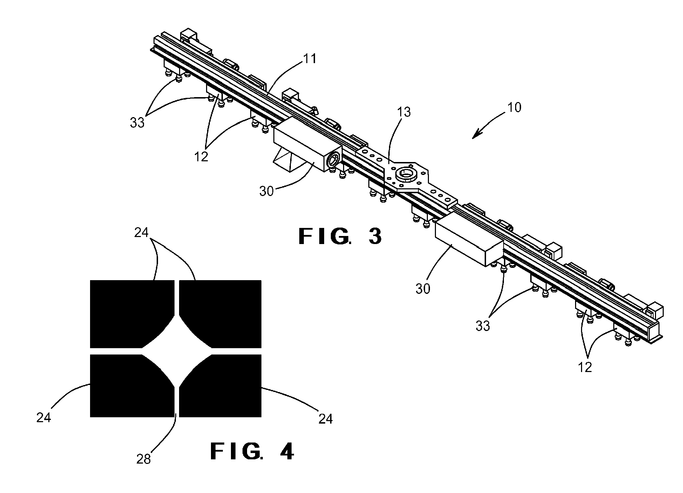

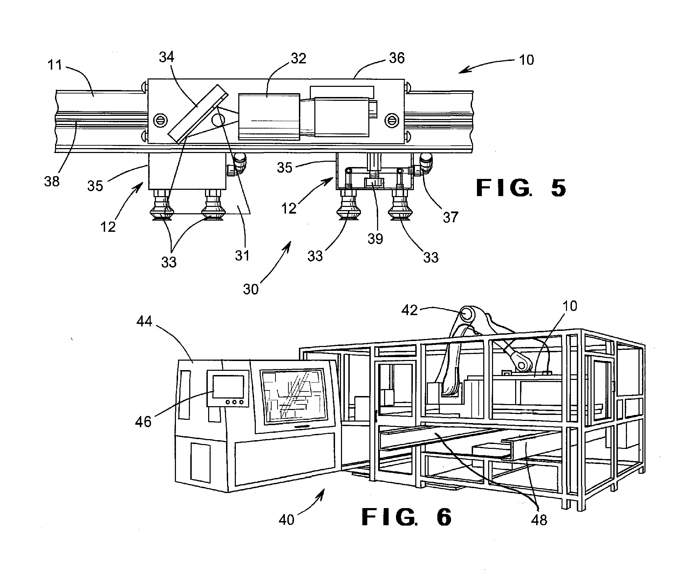

The layup product function of the invention is to take strings of solar cells from the Komax Solar stringer and place them in specific locations on a glass substrate layered with encapsulation material (EVA). As shown in Fig. 6, a robotic arm **42** is used to transfer the strings from a stringing machine **44** to the glass substrate. The strings are picked up using a pickbar **10** shown in Figs. 1 and 3 attached to the end of the robotic arm **42.** The pickbar **10** has an elongated body **11** with a plurality of suction cup vacuum grippers **12** including suction cups **33** for gripping each cell and extending from a bottom surface of the body. The length of the body **11** depends upon the number and size of the cells to be gripped, and typically can be about two meters long. In Figs. 1 and 3, the pickbar **10** has twelve grippers **12** for gripping strings up to twelve cells long. A mounting mechanism **13** is positioned on an upper surface of the body **11** midway between the ends for attaching the pickbar **10** to a free end of the arm of the robot **42.**

Strings of solar cells are placed into a matrix of a specified number strings side by side. Fig. 2 shows an example matrix **20** formed of five strings **22** extending vertically in parallel and each having six solar cells **24.** The strings could have more or less solar cells. The strings **22** are placed on a glass substrate or panel **26** in the order of the "String #" from "1" through "5". The key performance challenge is to place the strings **22** parallel to each other with adjacent edges separated by a user specified gap **28** and centered on the glass substrate **26.** Matrix dimensional aspects are critical for customer acceptance.

The basic concept of the invention is to position two sensor assemblies **30,** such as camera assemblies or the equivalent, at separate locations on a side surface of the body **11** of the pickbar **10** as shown in Fig. 3. The sensor position is based on string length. Fig. 3 illustrates the sensor assemblies **30** as enclosure boxes positioned for an eight cell string. During the string placement operation, the sensor assemblies **30** are used to detect the cells **24** to provide a capability to locate each string **22** relative to another feature. Such features can range from a reference fiducial **27** (Fig. 2) used for the first string placement to an existing string **22** located on the glass substrate **26.**

For string to panel alignment, the robotic arm **42** will move to a fiducial position located close to the panel **26.** There are two fiducials **27** (Fig. 2) calibrated to the edge of the panel. A vision system utilizing cameras in the sensor assemblies **30** acquires images, which images include the string **22** gripped by the pickbar **10** and the fiducial features **27.** From the acquired images, software will locate X, Y edge information and calculate X, Y, and theta feedback for the robotic arm to compensate the incoming string to the fiducials. Multiple iterations will occur until the placement is within the desired tolerances at which point the string **22** is placed on the panel **26.** Once the alignment to the fiducials **27** is complete the robotic arm **42** will move the calibrated distance between the fiducials and the panel plus the desired distance relative to the edge of the panel as specified by the customer for the desired position of the solar cell string on the panel.

For string to string alignment the robotic arm **42** will position the string **22** just above the surface of the glass substrate **26** at an X, Y position calculated by the dimension specifications of the material. At this position the vision system will locate the string **22** on the pickbar **10** to the adjacent string **22** already on the glass substrate **26.** From the acquired images the software will locate X, Y edge information and calculate X, Y, and theta feedback for the robot to compensate the incoming string to the existing string. Multiple iterations will occur until the placement is within the desired tolerances at which point the string **22** is placed on the panel **26.**

The locating features can be the corners of four cells **24** and the glass substate **26** can be backlit to provide an outline of the cells as shown in Fig. 4. Cell corners can range from square to round. Fig. 4 illustrates the worst case scenario of a rounded corner. The field of view (FOV) size of the sensing mechanism should be approximately 80 to 100mm longside in order to obtain sufficient corner edge information beyond the rounded portions of the corners. Any type of lighting, such as front lighting or ambient lighting, also can be used to illuminate the locating features.

To maintain flexibility to accommodate various product combinations which include two cell sizes, 125mm and 156mm, and various strings lengths, the sensor assemblies **30** must be adjustable for movement along the body **11** of the pickbar **10.**

Additional to the use of the sensor assemblies **30** for alignment, they also can be used to verify the final dimension once the string **22** has been placed on the glass substrate **26.** During alignment one string is approximately 5mm above the panel, but for measurement the string is already placed on the glass and the sensor assembly **30** is used to acquire the data during the period of vacuum release. The data will provide a confirmation of the distances when the string is at its final placed position. This feature provides two key benefits:
- A reliable way to measure the dimensions on real product.
- The ability to institute the parameter as a control parameter to the manufacturing process.

Fig. 5 is an elevation view of one of the sensor assemblies **30** cut away to show a camera **32** positioned to receive an image **31** adjacent to one of the vacuum grippers **12** mounted on the pickbar **10.** The camera **32** acquires the image **31** from a reflector **34** mounted in an enclosure **36** with the camera. The enclosure **36** is slidably mounted on a longitudinally extending track **38** to permit adjustment of the camera sensor **30** along the length of the body **11.** The adjustment can be performed manually or with an actuator (not shown). Each vacuum gripper **12** includes four of the suction cups **33** (see Figs. 1 and 3) positioned in a generally square pattern and extending downwardly from a housing **35** mounted on the bottom of the body **11.** More or less suction cups could be used. Each of the suction cups **33** is in fluid communication with a vacuum source (not shown) through a conduit network **37.** The vacuum gripper **12** can be attached to the bottom surface of the pickbar body **11** by a fastener **39.**

Although the camera **32** shown in Fig. 5 acquires the image **31** from the reflector **34,** the camera could be mounted to view downwardly which would eliminate the reflector. Furthermore, other types of suitable sensors can be substituted for the camera **32.** Examples are sensors based upon laser beams, the Hall effect, air streams and ultrasonic waves that can determine distance and/or position.

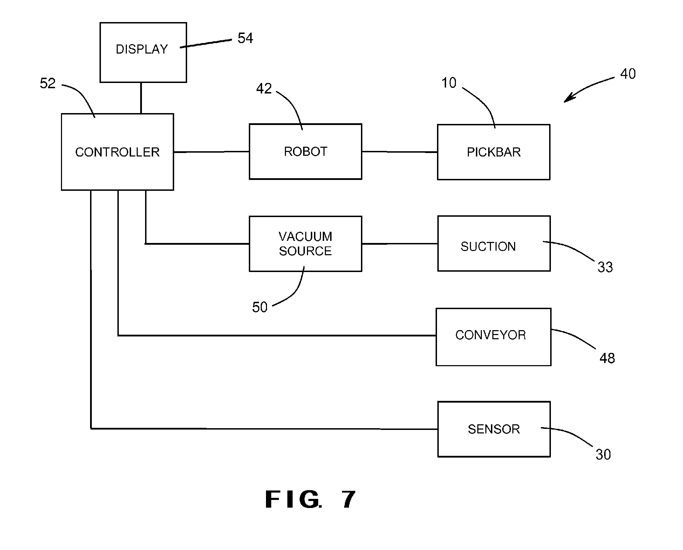

Fig. 6 is a perspective view of a solar cell string layup system **40** according to the invention. The system **40** includes the robotic arm **42** having the pickbar **10** mounted at a free end of the arm by the mounting mechanism **13** (Figs. 1 and 3). Movement of the robotic arm **42** is controlled by the software program running in a layup controller **52** shown in Fig. 7. The solar cell strings **22** are fabricated by the stringing machine **44** connected to and operated by a stringer user interface **46.** The glass panels **26** are placed on a horizontally extending surface of a conveyor represented by a pair of "C" shaped beams **48** over which the pickbar **10** can be positioned. The layup controller **52** also controls the application of vacuum to the suction cups **33,** the acquisition of position signals by the sensor assemblies **30,** the movement of the sensor assemblies **30** along the pickbar **12,** and the movement of the conveyor **48.**

Fig. 7 shows the control system for operating the solar cell string layup system **40** according to the method of the invention. The layup controller **52** is connected to a display screen **54** for generating a visual presentation of the performance verification information from the solar cell string layup operation. The layup controller **52** is also connected to the robotic arm **42** to control movement of the arm with the pickbar **10** attached thereto. The controller **52** also is connected to a vacuum source **50,** the conveyor **48** and the sensor assemblies **30.** As explained above, the layup controller **52** moves the robotic arm **42** to position the pickbar **10** adjacent a first one of the solar cell strings **22.** The controller **52** actuates the vacuum source **50** to cause the suction cups **33** to grip associated ones of the cells **24** of the solar cell string **22.** Then the controller **52** directs the robotic arm **42** to position the gripped string **22** over the glass panel **26** placed on the support conveyor **48** and moved into a layup position as directed by the controller **52.** The layup controller **52** activates the sensor assemblies **30** to locate the fiducials **27** and directs the robotic arm **42** to position the first string **22** on the panel **26.** Then the controller **52** causes the vacuum source **50** to remove the vacuum to release the solar cell string **22.** The controller **44** then repeats the above operations for each subsequent solar cell string using the adjacent solar cell string on the panel as a reference.

In accordance with the provisions of the patent statutes, the present invention has been described in what is considered to represent its preferred embodiment. However, it should be noted that the invention can be practiced otherwise than as specifically illustrated and described without departing from its spirit or scope.

## Claims

1. A pickbar for layup of a solar cell strings on a substrate comprising:
an elongated body having a plurality of vacuum grippers mounted thereon each spaced along the body for gripping an individual solar cell of a solar cell string when the vacuum grippers are connected to a vacuum source; and
at least one sensor assembly mounted on the pickbar for generating a signal representing a position of the solar cell string when gripped by the vacuum grippers, the signal including a position of a feature of a solar cell substrate when the pickbar is adjacent the substrate.

2. The pickbar according to Claim 1 wherein each of the vacuum grippers includes four suction cups in fluid connection with a conduit network connected to a vacuum source for generating the vacuum.

3. The pickbar according to Claim 1 wherein the at least one sensor assembly includes a camera for acquiring an image of the solar cell string and generating the signal.

4. The pickbar according to Claim 3 including a reflector for directing the image to the camera.

5. The pickbar according to Claim 1 including a track attached to the elongated body and wherein the sensor assembly is slidably mounted on the track for moving the sensor assembly relative to the vacuum grippers.

6. A system for layup of a solar cell string on a substrate comprising:
a robotic arm;
a pickbar attached to a free end of the robotic arm for gripping a solar cell string, the pickbar having an elongated body with a plurality of vacuum grippers spaced along the body each for gripping an individual solar cell of the solar cell string;
a vacuum source in fluid communication with the vacuum grippers and applying a vacuum through the vacuum grippers to grip the solar cells; and
a controller connected to the robotic arm for positioning the solar cell string gripped by the pickbar on a substrate.

7. The system according to Claim 6 including a pair of sensor assemblies mounted on the pickbar each for generating a signal representing a position of a portion of the solar cell string and a feature of the substrate, the controller being connected to the sensor assemblies and being responsive to the signals for positioning the gripped solar cell string relative to the substrate.

8. The system according to Claim 7 wherein each of the sensor assemblies includes a camera for acquiring an image of the position and the feature, and generating the signal.

9. The system according to Claim 8 wherein each of the sensor assemblies includes a reflector for directing the image to the camera.

10. The system according to Claim 7 wherein the features are one of fiducials on the substrate and corner edges of solar cells of another solar cell string on the substrate.

11. The system according to Claim 7 including a display screen connected to the controller for displaying performance verification information generated by the controller in response to the signals from the sensor assemblies.

12. The system according to Claim 7 including a track attached to the body and wherein the sensor assemblies are slidably mounted on the track for moving the sensor assemblies relative to the vacuum grippers.

13. The system according to Claim 6 wherein each of the vacuum grippers includes four suction cups positioned in a generally square pattern and being in fluid communication with the vacuum source.

14. A method for layup of a solar cell string on a substrate comprising the steps of:
providing a pickbar having an elongated body with a plurality of vacuum grippers and a sensor assembly mounted thereon;
positioning the pickbar adjacent a solar cell string and applying vacuum to the vacuum grippers to grip the solar cell string;
moving the pickbar to position the solar cell string adjacent a surface of a substrate;
operating the sensor assembly to generate a signal representing a position of a portion of the solar cell string and a feature of the substrate; and
moving the pickbar in response to the signal to place the solar cell string at a desired position on the substrate and releasing the solar cell string from the pickbar by removing the vacuum.

15. The method according to Claim 14 wherein for string to substrate alignment, the following steps are performed:
a) moving the robotic arm to place the pickbar with the solar cell string at a fiducial position located close to a surface of the substrate;
b) operating the sensor to generate the signal which includes the position of the portion of the solar cell string gripped by the pickbar and a fiducial feature on the substrate;
c) from the signal, locating X, Y edge information and calculating X, Y, and theta feedback for the robotic arm, and moving the robotic arm to compensate the solar cell string to the fiducial feature;
d) if necessary, performing at least one iteration of steps b) and c) until the solar cell string is positioned within desired tolerances of the desired position; and
e) operating the robotic arm to place the solar cell string on the substrate surface.

16. The method according to Claim 14 wherein for string to string alignment, the following steps are performed:
a) moving the robotic arm to place the pickbar with the solar cell string at an X, Y position calculated from dimension specifications of the substrate;
b) operating the sensor to generate the signal which includes the position of the portion of the gripped solar cell string and a portion of another solar cell string on the substrate;
c) from the signal, locating X, Y edge information and calculating X, Y, and theta feedback for the robotic arm, and moving the robotic arm to compensate the gripped solar cell string to the another solar cell string;
d) if necessary, performing at least one iteration of steps b) and c) until the gripped solar cell string is positioned within desired tolerances of the desired position; and
e) operating the robotic arm to place the gripped solar cell string on the substrate surface.

17. The method according to Claim 16 wherein the signal includes the position of adjacent corners of two solar cells of the gripped solar cell string and two solar cells of the another solar cell string.

18. The method according to Claim 14 including mounting the pickbar on a free end of a robotic arm and controlling the arm to perform the positioning step and the moving steps.
